# EUROPEAN PATENT SPECIFICATION

(11) **EP 1 720 076 B1**
(45) Date of publication and mention of the grant of the patent: **12.08.2015**
(21) Application number: 06008132.0
(22) Date of filing: 19.04.2006
(51) Int. Cl.: G03F 7/36

(54) **Method for thermal development of a photosensitive element using an oriented development medium**
Verfahren zur thermischen Entwicklung eines lichtempfindlichen Elements unter Verwendung eines ausgerichteten Entwicklungsmediums
Procédé de développement thermique d'un élément photosensible utilisant un support de développement orienté

(30) Priority: 19.04.2005 US 108967
(43) Date of publication of application: 08.11.2006
(73) Proprietor: E. I. du Pont de Nemours and Company, Wilmington, DE 19898 (US)
(72) Inventor: Hackler, Mark A., Ocean, New Jersey 07712-3343 (US); Weaver, Sheila, North Brunswick, New Jersey 08902 (US); Kannurpatti, Anandkumar R., Pennsylvania 19342 (US)
(74) Representative: Hoffmann, Benjamin

(56) References cited:
- WO-A-01/18604

## Description

### BACKGROUND OF THE INVENTION

### Field of the Invention

This invention relates to a method for thermally developing a photosensitive element, and particularly to a method that includes contacting to the element a development medium having a predetermined directionality.

### Description of Related Art

Flexographic printing plates are well known for use in printing surfaces which range from soft and easy to deform to relatively hard, such as packaging materials, e.g., cardboard, plastic films, aluminum foils, etc.. Flexographic printing plates can be prepared from photosensitive elements containing photopolymerizable compositions, such as those described in U.S. Patents 4,323,637 and 4,427,759. The photopolymerizable compositions generally comprise an elastomeric binder, at least one monomer and a photoinitiator. Photosensitive elements generally have a photopolymerizable layer interposed between a support and a coversheet or multilayer cover element. Upon imagewise exposure to actinic radiation, photopolymerization of the photopolymerizable layer occurs in the exposed areas, thereby curing and rendering insoluble the exposed areas of the layer. Conventionally, the element is treated with a suitable solution, e.g., solvent or aqueous-based washout, to remove the unexposed areas of the photopolymerizable layer leaving a printing relief which can be used for flexographic printing. However, developing systems that treat the element with a solution are time consuming since drying for an extended period (0.5 to 24 hours) is necessary to remove absorbed developer solution.

As an alternative to solution development, a "dry" thermal development process may be used which removes the unexposed areas without the subsequent time-consuming drying step. In a thermal development process, the photosensitive layer, which has been imagewise exposed to actinic radiation, is contacted with an absorbent material at a temperature sufficient to cause the composition in the unexposed portions of the photosensitive layer to soften or melt and flow into an absorbent material. See U.S. Patents 3,060,023 (Burg et al.); 3,264,103 (Cohen et al.); 5,015,556 (Martens); 5,175,072 (Martens); 5,215,859 (Martens); and 5,279,697 (Peterson et al.). The exposed portions of the photosensitive layer remain hard, that is do not soften or melt, at the softening temperature for the unexposed portions. The absorbent material collects the softened un-irradiated material and then is removed from the photosensitive layer. The cycle of heating and contacting the photosensitive layer may need to be repeated several times in order to sufficiently remove the flowable composition from the un-irradiated areas and form a relief structure suitable for printing. After such processing, there remains a raised relief structure of irradiated, hardened composition that represents the irradiated image.

Processors for thermal development of flexographic printing elements are known. U.S. 5,279,697 and U.S. 6,797,454 which corresponds to WO-A-01/18604 each describe an automated process and apparatus for handling an irradiated printing element and accomplishing repeated heating and pressing to remove the unirradiated composition from the element with a web of absorbent material. The apparatus includes a hot roll that delivers the absorbent material with the photosensitive element. The absorbent material contacts the hot surface of the hot roll elevating the temperature of the absorbent material. The heated absorbent material transfers the heat to the photosensitive element, melting a portion of the composition layer, and absorbs at least a portion of the softened or liquefied composition layer.

A problem sometimes arises during thermal development where the absorbent material is a continuous web, and in particular a web of nonwoven material. After the heated absorbent material is brought into contact with the photosensitive element and collects the softened unirradiated material, the web of absorbent material then separates from the photosensitive element. However, the continuous web of the absorbent material can stick or adhere to the element while being separated from the photosensitive element. The ability to separate from the element can vary with the relief image forming. Portions of the relief image which are imaged, peel easily as the web separates whereas portions of the relief image which are non-imaged, cause the web to stick to the element and peel with increased force.

Sticking of the web to the element can cause fibers from the nonwoven web to separate from the web and adhere to the surface of the element. In more severe cases, the web sticking to the element causes the nonwoven web to fracture or separate from itself, forming a layer-like carpet of fibers on the surface of the element. The removal of fibers of the web can also weaken the nonwoven web for subsequent cycles of removal and separation. Fibers or the layer-like carpet of fibers are not removed from the surface by subsequent cycles of heating with the hot roller. Fibers on the relief surface of the printing form interfere with ink transfer from the form to the printing substrate and result in poor print quality.

In some severe cases, the web has insufficient strength to withstand the force necessary to peel the nonwoven web from the non-imaged areas of the element, and the web tears or breaks. When the web breaks, the molten polymer from the element can flow onto various surfaces in the processor including the hot roll and the drum support roll. As such, operations are suspended for a considerable downtime while the web is re-threaded through the processor and the tacky molten polymer is removed from various interior surfaces. If the molten polymer remains on the hot roll, the polymer tends to build up and harden on the roll, which can then impress patterns into the surface of subsequently processed printing forms.

It is thus desirable to provide a method for thermal development using a development medium that can withstand the peeling forces necessary to overcome sticking of the medium to the non-imaged areas and separate the medium from the element. It is also desirable to provide a method for thermal development that minimizes or eliminates the removal of fibers from a development medium by the element. Further, it is desirable to provide a method for thermal development using a development medium that does not fracture or break.

### SUMMARY OF THE INVENTION

In accordance with this invention there is provided a method for forming a relief pattern from a photosensitive element according to claim 1.

### DESCRIPTION OF THE PREFERRED EMBODIMENT(S)

The present invention is a method for thermally developing a photosensitive element, preferably to form a relief pattern suitable for use as a flexographic printing form. The present invention contemplates a method capable of heating the photosensitive element having a layer of composition capable of being partially liquefied to a temperature sufficient to melt or soften or liquefy at least a portion of the layer for any purpose. In particular, the present invention relates to method for thermally developing the photosensitive element using a development medium having a predetermined directionality that is oriented to increase peel strength of the development medium which allows the medium to overcome the forces applied while removing the medium from the photosensitive element.

Thermal development heats the photosensitive element to a development temperature that causes uncured portions of the composition layer to liquefy, i.e., melt or soften or flow, and be carried away by contact with a development medium. The development medium may also be referred to herein as development material, absorbent material, absorbent web, and web. Cured portions of the photosensitive layer have a higher melting or softening or liquefying temperature than the uncured portions and therefore do not melt, soften, or flow at the thermal development temperatures. Thermal development of photosensitive elements to form flexographic printing plates is described in U.S. 5,015,556; U.S. 5,175,072; U.S. 5,215,859; and WO 98/13730. The photosensitive element includes a substrate and at least a composition layer mounted on the substrate. The composition layer is capable of being partially liquefied.

The term "melt" is used to describe the behavior of the unirradiated portions of the composition layer subjected to an elevated temperature that softens and reduces the viscosity to permit absorption by the absorbent material. The material of the meltable portion of the composition layer is usually a viscoelastic material which does not have a sharp transition between a solid and a liquid, so the process functions to absorb the heated composition layer at any temperature above some threshold for absorption in the development medium. Thus, the unirradiated portions of the composition layer soften or liquefy when subjected to an elevated temperature. However throughout this specification the terms "melting", "softening", and "liquefying" may be used to describe the behavior of the heated unirradiated portions of the composition layer, regardless of whether the composition may or may not have a sharp transition temperature between a solid and a liquid state. A wide temperature range may be utilized to "melt" the composition layer for the purposes of this invention. Absorption may be slower at lower temperatures and faster at higher temperatures during successful operation of the process.

The use of the term absorption in defining the relative physical property between the development medium and the melted uncured elastomeric composition is not intended to be limiting to particular absorptive phenomena. There need not be penetration of the melted composition into the body of fibers, filaments or particles. The absorption into the bulk of the development medium may be only by surface wetting of the interior bulk. The driving force for the movement of the melted elastomeric composition into the absorptive areas of the development medium may be one or more of surface tension, electrical forces, polarity attraction or other physical forces known to assist in promoting philicity, adsorption, of absorption of materials. The driving force may also include pressure driven flow into a porous media.

The development medium includes an absorbent material that is selected to have a melt temperature exceeding the melt or softening or liquefying temperature of the unirradiated or uncured portions of the radiation curable composition at the same operating temperatures. Preferably, the selected absorbent material withstands temperatures required to process the photosensitive element during heating. The development medium is typically a continuous web in an automated thermal development process, but can be in sheet form. The development medium can include one or more layers of the absorbent material, which can be the same or different. The absorbent material should also possess a high absorbency for the molten elastomeric composition as measured by the grams of elastomer that can be absorbed per square millimeter of the absorbent medium. The development medium is selected from absorbent materials that contain a fraction or a substantial fraction of their included volume as void volume.

Materials suitable for the development medium include non-woven materials, paper stocks, fibrous woven materials, open-celled foams, and porous materials. Preferred for the development medium are non-woven materials composed of nylon, polyester, polypropylene, polyethylene, and combinations of non-woven materials thereof. Particularly preferred are non-woven continuous webs of nylon or polyester.

The development medium is preferably a non-woven material having a bonded side. In a preferred method of the invention, the bonded side of the development medium can be placed in contact with the element. The development medium may additionally comprise a second bonded side, wherein one of the first or second bonded sides has a higher degree of bonding than the other side. In a preferred method of the invention, the side of the development medium having the higher degree of bonding is placed in contact with the element.

While prior art has indicated that the development medium should have good tear resistance, it was surprising and unexpected to find that the development medium has a particular directionality that provides improved strength to survive peeling from the photosensitive element during thermal development. The development medium has improved peel strength to survive peeling from the non-imaged areas of the photosensitive element when the development medium is oriented in one direction as compared to 180 degrees opposite to the direction. Further, in one embodiment of a nonwoven development medium, the medium has a first side and a second side (i.e., top side and bottom side) in which the improved peel strength is in one direction for the first side and in an opposite direction for the second side of the medium.

Peel strength is the ability of the development medium to separate from an adhesive or tacky surface of the element without fracturing, tearing, or breaking. Peel strength may also be expressed as a (maximum) force the development medium can withstand during peeling process without fracture, tearing, or breaking. Peeling of the development medium from the photosensitive element is equivalent to removing or separating of the development medium from the photosensitive element. Fracture or fracturing of the development medium is the removal of components (in whole or in part) or portions of the material forming the medium, such as fiber/s or a layer of fibers from a nonwoven or woven material.

Non-imaged areas of the photosensitive element are tacky unpolymerized portions and can cause the development medium to stick or adhere, but areas where the photosensitive composition is partially polymerized increases the propensity for the development medium to tear, break, or fracture such that portions of the development medium remain stuck. The relief structure can include partially polymerized areas where exposure to actinic radiation did not completely polymerize the composition, such as, for example, a surface of the floor forming the base of the relief structure. The surface of the floor may be partially polymerized since the floor is formed by exposing through the backside of the element that creates a gradient in the degree of photopolymerization through the thickness of the layer. The ultimate floor surface can reside somewhere in this photopolymerization gradient. The partially polymerized areas are very tacky and have a higher cohesive strength than the unpolymerized photopolymer. The development medium is most likely to contact areas of partial polymerization as the depth of the relief structure is forming. Thus the development medium typically has an increasing tendency to stick or adhere to the element as development proceeds, and particularly in the later cycles of processing. Orienting the development medium for increased peel strength improves the likelihood that the development medium can overcome the adhesive forces in the non-imaged areas and especially the cohesive forces associated with the partially polymerized areas, without fracturing, tearing or breaking of the medium. One of ordinary skill in the art may expect in some circumstances that the development medium may stick or adhere to imaged areas of the element.

This directionality of the strength for the development medium is particularly exhibited in nonwoven materials, but it is expected that the other materials suitable for the development medium may also exhibit such directionality in strength. While the Applicants do not wish to be held to any particular reason, the directionality of strength for the development medium may be induced during the manufacture of the medium. For example, the directionality of strength for a nonwoven development medium may be induced by the manufacturing process direction for fiber spinning and deposition, formation of lamellae in the medium, the type (e.g., chemical, thermal, mechanical) and degree of bonding of the side or sides of the medium, etc.

When the development medium is a continuous web, typically the directionality of the strength of the development medium is associated with the machine direction of manufacture. It should be understood that the development medium may have a peel strength that is greatest in an orientation other than that aligned with a machine direction, but use of this orientation may not be a viable option particularly in commercial thermal development systems in which the development medium is a continuous web. The development medium may also be in sheet form for a thermal development process. In such case, the development medium may be prepared for use in a multiplicity of orientations (that is, the development medium may be aligned with a machine direction, or a transverse direction, or at any angle between the machine and transverse directions). It is possible that there may be a single preferred orientation, or a few select orientations, or a range of preferred (angle) orientations, for the development medium that provide the medium with increased peel strength for removal from the element.

In order to take advantage of the predetermined directionality of the development medium in a thermal development process, the development medium should be oriented so as to increase the peel strength of the development medium while removing the development medium from the exterior surface of the photosensitive element. During thermal development the development medium contacts the exterior surface of the photosensitive element, and is peeled away from the surface removing the molten tacky unpolymerized portions of the composition layer. The peeling action of the development medium exerts one or more forces on the medium, requiring the medium to have sufficient peel strength to overcome the exerted force/s. As such, aligning the direction of the development medium having the greatest peel strength for the side of the medium contacting the element with the forces applied while removing the medium from the element increases the peel strength of the medium and reduces or eliminates fracture, tearing, or breaking of the medium (compared to the peel strength of the development medium in which its not advantageously oriented).

When the development medium is a continuous web, it may be necessary to unwind and rewind the development medium as received from the manufacturer from one roll to another, one or multiple times, in order to orient the web properly for thermal process in an automatic development apparatus. Typically in an automatic development apparatus the development medium can only transport in one direction for contacting to and removal from the photosensitive element. So the web of the development medium should be (pre-)wound on a supply roll for the apparatus such that the web dispenses from the supply roll and transports in the desired direction with the orientation of increased peel strength.

For a development medium composed of fibers, it is also desirable that the fibers are bonded so that the fibers are not deposited into the printing form during development. It may be preferred that the more highly bonded side of the development medium contacts the surface of the element during thermal development.

The Applicants have found that the directionality of the peel strength for a particular development medium can be determined with a tape-peeling test. The tape-peeling test is easier to perform than testing of the medium in the thermal development apparatus. The tape-peeling test is conducted at room temperature and separates an adhesive tape from the development medium. The tape-peeling test is done as a series which change the orientation of the development medium relative to the removal of a highly adhesive tape to determine the direction of greatest peel strength for the development medium. The tape-peeling test can be conducted manually as described in Example 1 or can be conducted automatically by an instrument for evaluating peel strength of materials.

A suggested automated tape peeling test can be conducted on a Zwick Peel Tester Model Z2.5, (from Zwick Roelle Group in Ulm, Germany), using a 10 Newton load cell. The tape used was an aggressive adhesive tape from 3M (St. Paul, Minnesota) type 8412, which has an adhesion to steel of 42 ounce per inch width (46 Newtons/100 mm) according to ASTM D-3330. The procedure for the tape-peeling test includes the following steps.
1) Cut samples of the development medium into 1.5 inch (3.8 cm) strips of at least 6 inches (15 cm) in length. Indicate on each sample strip the side of the development medium and winding direction relative to the core.
2) Cut the tape into 1 inch (2.5 cm) strips. Care should be taken to only contact one end of the tape with a surface. The rest of the tape should hang freely and not touch any surface once removed from the tape roll.
3) Align the tape strip over the strip of the development medium. Be careful not to touch the two together until properly aligned and ready to combine.
4) Press the tape strip and strip of development medium together by making parallel strokes in one direction along the length of the sample for 15 seconds. There should be good contact between the development medium and the tape with no trapped air bubbles.
5) Trim away any excess development medium and/or tape from the sample to a final sample width of about 1 inch (2.5 cm).
6) Place the sample under a weight for about 15 minutes. The weight should cover the sample. A suitable weight is a 2800 gram book.
7) Measure the thickness and width of each sample in millimeters. Enter measurements into instrument as prompted.
8) Turn on the Zwick Peel Test instrument, and set the peel speed for 4 inch (10 cm) / minute.
9) For each sample strip, start the peel by hand separating the tape from the development medium apart approximately 0.75 inch (1.9 cm).
10) Load the sample into the peel tester sample holder with the tape side up. The sample should be square in the holder and not sag.
11) Operate the peel tester per the operating procedure. Total distance of the peel separating the tape from the medium is 4 inch (10 cm).

Record the force required to separate the sample strips.

The tape-peeling test series should provide at least two distinct ranges of forces (low and high) to remove the tape form the development medium. The relatively low force represents orientation/s of the development medium that do not have sufficient peel strength to separate from the surface of the element and the development medium fractures, tears, or breaks. The relatively high force represents the orientation of the development medium that has sufficient peel strength to separate from the surface of the element without fracturing, tearing, or breaking. For the automated tape-peeling test previously described to evaluate a nonwoven development medium, forces of about 0.5 to 1 Newtons per millimeter represent orientations of the medium that do not have sufficient peel strength, and forces of at least about 2.5 to 3 Newtons per millimeter represent orientations that do have sufficient peel strength to remove from the element without fracturing, tearing, or breaking.

It should be understood that the actual measured force to separate the tape from the medium would likely change as materials, instrument, and procedure changes. The automated tape-peeling process is conducted to determine relative changes in force (peel strength). As such the actual measured force for each orientation of the development medium may be different as the components for the test may change, but the relatively high force would still indicate the orientation of the development medium having the higher peel strength. It is within the skill of those in the art to contemplate variations to the above suggested tape-peeling test procedure and alternative methods to determine peel strength of the medium. One such alternative method for evaluating peel strength is by the ASTM test method described for peel adhesion of pressure-sensitive tape, ASTM designation D3330/D3330M. The tape suitable for use in the peeling test should have an adhesive strength itself (that is, adhesion to steel) in the order of about 22.3 to 111.6 kg/m width of tape (20 to 100 ounce per inch width of tape), according to ASTM D3330. A tape having too low of adhesion will not fracture the development medium, and therefore show no difference in peel strength orientation. A tape having too high of adhesion will likely at least fracture (but also tear or break) the development medium in all test orientations, but should still show a relative difference in the maximum force before fracture between the orientations. A preferred tape has a backing of polyester or other dimensionally stable support.

Additionally, the tape-peeling test (manual or automated) can be evaluated for peel strength by mere observation of the resulting separated sample. The orientation of the development medium had insufficient peel strength if the surface of the development medium contacted by the tape appears tom or was tearing, has a break or a hole, or a layer-like portion of the medium has separated from itself (i.e., delaminate or fractured), or if the tape retains an appreciable portion of fibers from the medium.

The present invention provides a method for forming a relief pattern from the photosensitive element by orienting a predetermined directionality of the development medium to increase peel strength of the medium while removing the development medium from the exterior surface of the element. Advantageously, orienting the development medium to reinforce the strength of the development medium while being peeled from the photosensitive element reduces and can even eliminate the propensity for the development medium to fracture, tear, and break. Orienting the development medium thus can improve productivity of the thermal development apparatus. Further, orienting the development medium can reduce frequency or severity or even eliminate the tendency of the element to remove fibers from a nonwoven or a fibrous development medium and contaminate the relief surface of the photosensitive element

An apparatus suitable for thermally developing the photosensitive element is disclosed by Peterson et al. in U.S. Patent 5,279,697, and by Johnson et al. In U.S. 8,797,454 B1. The photosensitive element in all embodiments is in the form of a plate. Another apparatus suitable for thermally developing a cylindrically-shaped photosensitive element is described in published patent application number US 2006/0104675 A1. However, it should be understood that one of ordinary skill in the art could modify each of the disclosed apparatuses to accommodate the present inventive method for forming a relief pattern using the development medium of the present invention.

The method of the present invention includes heating of an exterior surface of the composition layer of the photosensitive element to a temperature sufficient to cause a portion of the layer to liquefy. The at least one photosensitive layer (and additional layer/s if present) can be heated by conduction, convection, radiation or other heating methods to a temperature sufficient to effect melting of the uncured portions but not so high as to effect distortion of the cured portions of the layer. One or more additional layers disposed above the composition layer may soften or melt or flow and be absorbed as well by a development medium. The photosensitive element is heated to a surface temperature above about 40 °C, preferably from about 40 °C to about 230 °C (104-446 °F) in order to effect melting or flowing of the uncured portions of the composition layer. The thermal treating steps of heating the photosensitive element and supplying the development medium to an exterior surface of the element can be done at the same time, or in sequence provided that the uncured portions of the photopolymerizable layer are still soft or in a melt state when contacted with the development medium.

The exterior surface of the photosensitive element can be heated by one or more sources in the thermal development apparatus. Independently or in any combination, the sources for heating are capable of heating the exterior surface of the photosensitive element to a temperature sufficient to cause a portion, i.e., an unirradiated portion, of the composition layer to liquefy. The method for heating each of the sources are not limited and can include, for example, an electrical core heater, electric heating blanket, steam, oil, hot air, and other heating sources that can provide a temperature sufficient to maintain or elevate the temperature of the exterior surface to melt a portion of the composition layer. A preferred heating source is a contact member, such as a hot roller, that heats the exterior surface of the composition layer while supplying the development medium to the element. The contact member supplying the development medium applies heat to the exterior surface of the element upon contact, raising the temperature of the element and causing the uncured portions of the composition layer of the element to melt, soften, or flow into the development medium.

The processor may include another source for heating that is a focused radiant heater/s directed at the exterior surface of the photosensitive element. The radiant heater can apply all or a portion of the heat needed to the exterior surface of the composition layer, to elevate the temperature of the exterior surface of the composition layer sufficient to melt the unirradiated portion of the composition layer, causing a portion of the layer to liquefy. The heater can include one or a plurality of tubular infrared heating bulb/s mounted in end supports that also provide electrical connections to the bulb/s. The heater can also include a reflector adjacent to the bulb/s that acts to focus and direct the infrared radiation toward the exterior surface of the element.

The apparatus includes a base member, such as for example, a drum, multiple rolls, or a planar surface, that supports the photosensitive element during thermal development. A preferred base member is a drum. The base member may include means for controlling a temperature of the outer surface of the base member, which helps to manage the thermal conditions experienced by the photosensitive element. In particular the means for controlling the temperature can be used to maintain the temperature of the support side of the photosensitive element. The means for controlling the base member temperature can include means for heating, means for cooling, and a combination thereof. The base member may be equipped with a heater, which is provided to keep the photosensitive element at a stable starting temperature independent of the surrounding environment. Any means of heating the base member is acceptable, as long as the power capacity of the heater is sufficient to maintain a fairly constant selected skin temperature on the outer surface of the drum. In this embodiment, the source for heating the base member is capable of providing a portion of the heat to elevate the temperature of the exterior surface of the composition layer sufficient to melt the unirradiated portion of the composition layer, causing a portion of the layer to liquefy. If the normal operating environment is carefully controlled to be at a constant temperature, the heater can be turned off or omitted from the apparatus. As is disclosed in U.S. Patent 6,797,454 B1, it is also possible that the base member be cooled by cooling means, such as, a blower directing a stream of air at the surface of the photosensitive element and the drum and/or by the circulating of cooling fluid beneath the surface of the base member to cool the element. It is also contemplated that a fluid, such as water, may be circulated beneath the surface of the base member to heat and or cool the element. The temperature of the outer surface of the base member is about 50 to 150 °F (10 to 65.6 °C), preferably 75 to 95 °F (23.9 to 35 °C).

The development medium is supplied to the exterior surface of the element with a contact member. The contact member has a cross-sectional shape that is not limited, and can include, for example, cylindrical, semi-cylindrical, elliptical, arcuate including convex and concave surfaces, dome, wedge, and rectangular shapes. The shape of the supply member can be symmetrical or asymmetrical. A cylindrically-shaped roll is a preferred contact member. Typically the contact member is heated, and thus may be referred to as a hot roll or roller. The contact member is positioned adjacent the photosensitive element that is supported by the base member, e.g., drum. When the development medium is supplied to contact the exterior surface of the photosensitive element, a nip is formed between the development medium supplied by the hot roll and the photosensitive element carried by the drum.

The development medium, particularly when in continuous web form, typically is under tension during thermal development. It should be understood that the development medium may be under tension control, velocity control, or a combination thereof for transport through the processor, but the development medium may still be under tension from at least at the point of separation of the development medium from the photosensitive element to a downstream drive mechanism. It is within the ordinary skill in the art to contemplate embodiments of tensioning the web, and implementing tension control, velocity control or combinations thereof for the transport of the medium through the apparatus. The tension in the development medium is at least 0.1 Ibs/in (0.2 Newtons/cm), and preferably at least 0.3 Ibs/in (0.5 Newtons/cm). In one embodiment where the development medium is a continuous web, a suitable range of tension is from about 0.1 to 10 lbs/in (0.2 to 17.5 Newtons/cm), preferably 0.3 to 5 lbs/in (0.5 to 8.8 Newtons/cm), and in another embodiment 0.5 to 1.0 lbs/in (0.875 to 1.75 Newtons/cm).

### Photosensitive Element

The present invention is not limited to the type of element that is thermally processed. In one embodiment, the photosensitive element includes a flexible substrate and a composition layer mounted on the substrate. The composition layer is at least one layer on the substrate capable of being partially liquefied. Preferably, the photosensitive element is an elastomeric printing element suitable for use as a flexographic printing form. The at least one layer on the substrate is preferably a photosensitive layer, and most preferably a photopolymerizable layer of an elastomeric composition wherein the photosensitive layer can be selectively cured by actinic radiation. As used herein, the term "photopolymerizable" encompasses systems that are photopolymerizable, photocrosslinkable, or both. In cases where the composition layer comprises more than one photosensitive layer on the flexible substrate, the composition of each of the photosensitive layers can be the same or different from any of the other photosensitive layers.

The layer of the photosensitive composition is capable of partially liquefying upon thermal development. That is, during thermal development the uncured composition must soften or melt at a reasonable processing or developing temperature. At least the exterior surface of the composition layer is heated to a temperature sufficient to cause a portion of the layer to liquefy, soften or melt.

The photosensitive layer includes at least one monomer and a photoinitiator, and optionally a binder. The at least one monomer is an addition-polymerizable ethylenically unsaturated compound with at least one terminal ethylenic group. Monomers that can be used in the photosensitive layer are well known in the art and include monofunctional acrylates and methacrylates, multifunctional acrylates and methacrylates, and polyacryloyl oligomers. Further examples of monomers can be found in U.S. Patents 4,323,636; 4,753,865; and 4,726,877. A mixture of monomers may be used.

The photoinitiator is a compound that generates free radicals upon exposure to actinic radiation. Any of the known classes of photoinitiators, particularly free radical photoinitiators may be used. Alternatively, the photoinitiator may be a mixture of compounds, one of which provides the free radicals when caused to do so by a sensitizer activated by radiation.

The optional binder is a preformed polymer that serves as a matrix for the monomer and photoinitiator prior to exposure and is a contributor to the physical properties of the photopolymer both before and after exposure. In one embodiment the optional binder is elastomeric. A nonlimiting example of an elastomeric binder is an A-B-A type block copolymer, where A represents a nonelastomeric block, preferably a vinyl polymer and most preferably polystyrene, and B represents an elastomeric block, preferably polybutadiene or polyisoprene. Other suitable photosensitive elastomers that may be used include polyurethane elastomers, such as those described in U.S. Patent Nos. 5,015,556 and 5,175, 072. The monomer or mixture of monomers must be compatible with the binder to the extent that a clear, non-cloudy photosensitive layer is produced.

The photosensitive layer may include additional additives such as colorants, processing aids, antioxidants, and antiozonants. The photosensitive element may include one or more additional layers on the side of the photosensitive layer opposite the substrate. Examples of additional layers include, but are not limited to, a release layer, a capping layer, an elastomeric layer, a laser radiation-sensitive layer, an actinic radiation opaque layer, a barrier layer, and combinations thereof. The one or more additional layers preferably are removable, in whole or in part, by contact with the development medium in the range of acceptable developing temperatures for the photosensitive element used. One or more of the additional other layers can cover or only partially cover the photosensitive composition layer. An example of an additional layer which only partially covers the photosensitive composition layer is a masking layer that is formed by imagewise application, e.g., ink jet application, of an actinic radiation blocking material or ink.

The release layer protects the surface of the composition layer and enables the easy removal of a mask used for the imagewise exposure of the photosensitive element. Materials suitable as the release layer are well known in the art. Suitable compositions for the capping layer and methods for forming the layer on the element are disclosed as elastomeric compositions in a multilayer cover element described in Gruetzmacher et al., U.S. Patent Nos. 4,427,759 and 4,460,675. The elastomeric capping layer is similar to the photosensitive layer in that after imagewise exposure the elastomeric capping layer is at least partially removable by contact with an absorbent material in the range of acceptable temperatures for the photosensitive element used.

In one embodiment, the laser radiation sensitive layer is sensitive to infrared laser radiation, and thus may be identified as an infrared-sensitive layer. The laser radiation sensitive layer can be on the photosensitive layer, or on a barrier layer which is on the photosensitive layer, or on a temporary support which together with the photosensitive element form an assemblage. Infrared-sensitive layers and actinic radiation opaque layers are well known in the art. The infrared-sensitive layer can be ablated (i.e., vaporized or removed) from the photosensitive layer on the side opposite the flexible substrate by exposure to infrared laser radiation. Alternatively, when the photosensitive element forms an assemblage with the support carrying the infrared-sensitive layer, the infrared-sensitive layer can be transferred from the temporary support to the external surface (the side opposite the flexible substrate) of the photosensitive layer by exposure to infrared laser radiation. The infrared-sensitive layer can be used alone or with other layers, e.g., ejection layer, heating layer, etc.

The infrared-sensitive layer generally comprises an infrared-absorbing material, a radiation-opaque material, and an optional binder. Dark inorganic pigments, such as carbon black and graphite, generally function as both infrared-sensitive material and radiation-opaque material. The thickness of the infrared-sensitive layer should be in a range to optimize both sensitivity and opacity to actinic radiation (e.g., has an optical density of ≥ 2.5). Such infrared-sensitive photoablative or phototransferable layer can be employed in digital direct-to-plate image technology in which the exposure by laser radiation removes or transfers the infrared-sensitive layer to form an in-situ mask on the photosensitive element. Suitable infrared-sensitive compositions, elements, and their preparation are disclosed in U.S. Patent 5,262,275;U.S. Patent 5,719,009; U. S. 5,607,814; U.S. Patent No. 5,506,086; U.S. Patent 5,766,819; U.S. Patent 5,840,463; and EP 0 741 330 A1. The infrared-sensitive layer preferably is removable by contact with an absorbent material in the range of acceptable developing temperatures for the photosensitive element used.

The photosensitive element of the present invention may further include a temporary coversheet on top of the uppermost layer of the photosensitive element. One purpose of the coversheet is to protect the uppermost layer of the photosensitive element during storage and handling. Depending upon end use, the coversheet may or may not be removed prior to imaging, but is removed prior to development. Suitable materials for the coversheet are well known in the art.

The substrate is selected to be tear resistant and must have a fairly high melt point, for example, above the liquefying temperature of the composition layer formed on the substrate. The material for the substrate is not limited and can be selected from polymeric films, foams, fabrics, and metals such as aluminum and steel. The substrate can be almost any polymeric material that forms films that are non-reactive and remain stable throughout the processing conditions. Examples of suitable film supports include cellulosic films and thermoplastic materials such as polyolefins, polycarbonates, and polyester. The shape of the support is not limited. The support may be in sheet form or in cylindrical form, such as a sleeve. The sleeve may be formed from single layer or multiple layers of flexible material. Flexible sleeves made of polymeric films are preferred, as they typically are transparent to ultraviolet radiation and thereby accommodate backflash exposure for building a floor in the cylindrical printing element. Multiple layered sleeves are also acceptable and may include an adhesive layer or tape between the layers of flexible material. The sleeve may also be made of non-transparent, actinic radiation blocking materials, such as nickel or glass epoxy. The sleeve typically has a wall thickness from 10 to 80 mils (0.025 to 0.203 cm) or more. Preferred wall thickness for the cylinder form is 10 to 40 mils (0.025 to 0.10 cm).

The substrate of the photosensitive element has a thickness of between about 0.01 mm and about 0.38 mm. The radiation curable composition layer is between about 0.35 mm and about 7.6 mm thick, with a preferred thickness of about 0.5 mm to 3.9 mm (20 to 155 mils).

The photosensitive element is prepared for thermal development by imagewise exposing the element to actinic radiation. After imagewise exposure, the photosensitive element contains cured portions in the exposed areas of the radiation curable composition layer and uncured portions in the unexposed areas of the radiation curable composition layer. Imagewise exposure is carried out by exposing the photosensitive element through an image-bearing mask. The image-bearing mask may be a black and white transparency or negative containing the subject matter to be printed, or an in-situ mask formed with the laser radiation sensitive layer on the composition layer, or other means known in the art. Imagewise exposure can be carried out in a vacuum frame or may be conducted in the presence of atmospheric oxygen. On exposure, the transparent areas of the mask allow addition polymerization or crosslinking to take place, while the actinic radiation opaque areas remain uncrosslinked. Exposure is of sufficient duration to crosslink the exposed areas down to the support or to a back exposed layer (floor). Imagewise exposure time is typically much longer than backflash time, and ranges from a few to tens of minutes.

For direct-to-plate image formation as disclosed in U.S. Patent 5,262,275;U.S. Patent 5,719,009; U. S. 5,607,814; U.S. Patent No. 5,506,086; U.S. Patent 5,766,819; U.S. Patent 5,840,463 and EP 0 741 330 A1 the image-bearing mask is formed in-situ with the laser radiation sensitive layer using an infrared laser exposure engine. The imagewise laser exposure can be carried out using various types of infrared lasers, which emit in the range 750 to 20,000 nm, preferably in the range 780 to 2,000 nm. Diode lasers may be used, but Nd:YAG lasers emitting at 1060 nm are preferred.

Actinic radiation sources encompass the ultraviolet, visible and infrared wavelength regions. The suitability of a particular actinic radiation source is governed by the photosensitivity of the initiator and the at least one monomer used in preparing the flexographic printing plates from the photosensitive element. The preferred photosensitivity of most common flexographic printing plates is in the UV and deep visible area of the spectrum, as they afford better room-light stability. The portions of the composition layer that are exposed to radiation chemically cross-link and cure. The portions of the composition layer that are unirradiated (unexposed) are not cured and have a lower melting or liquefying temperature than the cured irradiated portions. The imagewise exposed photosensitive element is then ready for heat development with the absorbent material to form a relief pattern.

An overall back exposure, a so-called backflash exposure, may be conducted before or after the imagewise exposure to polymerize a predetermined thickness of the photopolymer layer adjacent the support. This polymerized portion of the photopolymer layer is designated a floor. The floor thickness varies with the time of exposure, exposure source, etc. This exposure may be done diffuse or directed. All radiation sources suitable for imagewise exposure may be used. The exposure is generally for 10 seconds to 30 minutes.

Following overall exposure to UV radiation through the mask, the photosensitive printing element is thermally developed as described above to remove unpolymerized areas in the photopolymerizable layer and thereby form a relief image. The thermal development step removes at least the photopolymerizable layer in the areas which were not exposed to actinic radiation, i.e., the unexposed areas or uncured areas, of the photopolymerizable layer. Except for the elastomeric capping layer, typically the additional layers that may be present on the photopolymerizable layer are removed or substantially removed from the polymerized areas of the photopolymerizable layer.

After thermal development, the flexographic printing form may be post exposed and/or chemically or physically after-treated in any sequence to detackify the surface of the flexographic printing form.

### EXAMPLES

Pairs of sequential nonwoven mother rolls, CEREX® nylon nonwoven, type 2320, (from Cerex Advanced Fabrics) were selected for testing. One roll from a pair was slit and wound in the conventional fashion and the other was similarly slit but wound with the opposite side out (i.e., reverse wound). The conventional winding rolls were labeled "A" and the reverse wound rolls were labeled "B" following the number indicating the slit from the mother roll.

### Example 1

An aggressive adhesive tape (type 8412, from 3M) was adhered to one side of the nonwoven fabric and then peeled slowly by hand. Tape was cut 5 inches (12.7 cm) long by 4 inches (10.2 cm) wide. One edge of the tape was folded over to provide a handle for peeling it off. The tape was pressed down for 15 seconds and then allowed to stand for 30 seconds to provide some consistency among tests. The tape was then peeled off slowly at a large peel angle, while the nonwoven fabric was held in place with another hand. Tests were performed by peeling the tape toward the roll core and away from the roll core, on both the inside and outside of the slit roll as wound. For peeling the tape toward the roll core, the peel was started at the tape edge farthest from the roll core and the started edge of the tape was pulled toward the roll core. For peeling the tape away from the roll core, the peel was started at the tape edge closest to the roll core and the started edge of the tape was pulled away from the roll core. Results are shown below for 1 pair of fabric rolls. The nonwoven web was considered torn or tearing if an actual break or hole appeared in the web, or if a layer-like portion of the nonwoven web separated from itself (i.e., delaminated or fractured), or if an appreciable portion of fibers were removed from the nonwoven web by the tape. In the last two instances of evaluating the tape test, the nonwoven web is considered torn since the web is not completely intact and is weakened by the removal of the fibers or a fibrous layer.

| Winding Orientation | Side of Slit Roll Tested | Peeling toward core | | Peeling away from core | |
|---|---|---|---|---|---|
| | | # samples that tore | # samples tested | # samples that tore | # samples tested |
| A | Inside | 2 | 2 | 0 | 3 |
| A | Outside | 0 | 3 | 2 | 2 |
| B | Inside | 0 | 3 | 3 | 3 |
| B | Outside | 2 | 3 | 0 | 3 |

The results of the tape peeling test showed that the nonwoven web was more resistant to tearing when peeled in one direction versus the opposite direction. Further, that "strong direction" is reversed for the other side of the nonwoven web. That is, the nonwoven web was resistant to tearing in a reverse direction of peeling tape from the nonwoven web for one side of the nonwoven web compared to the opposite side of the same nonwoven web (inside versus outside). The results of tape peeling on the outside of "A" roll looked similar to the inside of "B" roll and vice versa. One would expect that in a thermal development processor where the nonwoven web roll is wound in the A configuration and oriented so that the inside surface of the nonwoven web contacts the printing element and peels away from the element toward the core should result in a higher propensity for tears in the nonwoven web. Improved performance would be expected by contacting the opposite side of the nonwoven web or rewinding the roll to reverse its orientation.

### Example 2

The following example further demonstrates that the propensity for tearing of the nonwoven web development medium is influenced by the orientation of the nonwoven web in the thermal development process.

Photosensitive elements were processed in a CYREL®FAST TD1000 thermal developer using a similar pair of sequential test rolls differing only by their winding at the time of slitting as described above. The photosensitive elements used were CYREL® flexographic printing elements, type DFM (67 mils (1.7 mm)). The printing elements were exposed through the support to UV radiation at 354 nm to give 20-25 mils (0.51-0.64 mm) of relief, but were given no main (imagewise) exposure. Standard processing conditions in this processor for the printing elements were modified as follows for this test. The number of cycles was increased from 11 to 15 with the conditions for cycle 11 being replicated for cycles 12 through 15. The IR power (for the IR preheater) was reduced to half of the standard value for all cycles. The pressure was maintained at the value used in cycle 1 for all cycles. The heated roll temperature was varied as described below.

A pair of sequential mother rolls of the nonwoven web was prepared as described above. Roll 2A was slit and wound in the conventional fashion, and roll 2B was slit and wound with the opposite side out. For each test series, one roll of the nonwoven web was loaded into the supply side of the thermal processor and dispensed through the designated path of the web including transport over the heated roll to the windup. Printing elements were processed at different heated roll temperatures. The heated roll temperature started at 315°F (157°C) and was decreased by 20°F (11°C) increments until sticking of the nonwoven web to an exterior surface of the printing element was observed. One element was then processed at a heated roll temperature that was increased by 10°F (5.6'C) over the temperature at which the nonwoven web stuck to the element. Another element was processed at a heated roll temperature that was between the temperatures where the nonwoven web had stuck and where the nonwoven web had not stuck to the etement. Lowering the heated roll temperature until the nonwoven web stuck to the element represented an extreme condition that easily demonstrated the propensity of a nonwoven web to tear relative to the orientation of the nonwoven web and dlrectlonality of the removal of the nonwoven web from the printing element.

The results are shown below beginning at 295°F (146°C):

| Roll ID | Hot Roll Temp in °F (°C) | Sticking? | Pass | Notes |
|---|---|---|---|---|
| 2A | 295 (146) | N | - | |
| 2A | 275(135) | Y | 13 | Nonwoven web stuck on pass 13 |
| 2A | 285 (141) | Y | 13 | Nonwoven web stuck on pass 13 |
| 2A | 290 (143) | Y | 15 | Nonwoven web stuck and started to tear in last pass |
| 2B | 295 (146) | N | - | |
| 2B | 275(135) | N | - | |
| 2B | 265 (129) | Y | 12 | Nonwoven web stuck on pass 12 |
| 2B | 270 (132) | N | - | |

| | | | | |
|---|---|---|---|---|
| Note that the 265°F (129°C) was only 10°F (5.6°C) cooler because a larger step would result in a heated roll that would be much too cold. | | | | |

The results of the first two series of tests clearly indicated that there is a drfference between the inside surface and the outside surface of the nonwoven web for thermal development. The side of the roll 2B that was in contact with the printing element in this winding orientation has a reduced propensity to tear (that is, is stronger) compared to the opposite side that was used in roll 2A.

Next the remaining portions of roll 2A and roll 2B were rewound. The outside surface of the roll remained the outside surface of the rewound roll. However, the roll was rotated 180° so that it could be reloaded onto the unwind of the thermal processor and dispensed in the standard configuration. This resulted in the same side of the nonwoven web contacting the element, but the nonwoven web was now traversing through the processor in the opposite direction from how it would have done so using the original winding. Another series of tests at the different heated roll temperatures were conducted with elements prepared as described above. The results follow.

| Roll ID | Hot Roll Temp in °F (°C) | Sticking? | Pass | Notes |
|---|---|---|---|---|
| 2A rw | 270 (132) | N | | |
| 2A rw | 265 (129) | N | | |
| 2B rw | 290 (143) | Y | 15 | Nonwoven web stuck and started to tear in last pass |
| 2B rw | 285 (141) | Y | 12 and 13 | Nonwoven web tore in 1 spot in pass 12, 2 spots in pass 13 |

The results were that rewound roll 2A performed similarly to roll 2B (before rewinding) and much better than roll 2A before rewinding. Likewise, rewound roll 2B stuck to the element at conditions similar to those where roll 2A (before rewinding) had stuck to the element. This also showed that even though the same side of the nonwoven web was in contact with the element, the direction that the element is removed from the nonwoven web can influence the propensity for tearing of the nonwoven web. The side of roll 2A (rewound) that was in contact with the printing element in this winding orientation has a slightly reduced propensity to tear compared to the opposite orientation that was used in roll 2B. However, the effect of the winding orientation is much more significant than the effect between the sides of the web for these samples.

These results were also consistent with the tape tests in Example 1. Thus, orienting the strong direction of the side of the nonwoven web development medium to contact the printing element with the peel direction (that is, the removal of the element from the nonwoven web) in the thermal developer reduces the propensity to tear the web as indicated by minimum acceptable heated roll temperatures.

## Claims

1. A method for forming a relief pattern from a photosensitive element having an exterior surface and containing a composition layer capable of being partially liquefied, comprising:
imagewise exposing the photosensitive element to actinic radiation, wherein after imagewise exposure the photosensitive element contains cured portions in the exposed areas of the composition layer and uncured portions in the unexposed areas of the composition layer;
heating the exterior surface to a temperature sufficient to cause the uncured portions of the layer to liquefy;
contacting the exterior surface with a development medium having a predetermined directionality; and
peeling the development medium from the exterior surface wherein the liquefied portions of the photosensitive element in contact with the development medium are also carried away;
**characterised in that**
the contacting step is performed by orienting the development medium to align it in the direction having the greatest peel strength thus reducing or eliminating fracture, tearing or breaking of the medium during its removal, said peel strength being the peel strength for the side of the medium contacting the element which allows the medium to overcome the forces applied while peeling the development medium from the exterior surface, wherein the peel strength of the development medium is determined offline on an instrument for peel testing.

2. The method of Claim 1 wherein the development medium is a nonwoven material.

3. The method of Claim 1 wherein peel testing on the instrument comprises:
a) creating a test sample by placing an adhesive tape into contact with a side of the development medium;
b) loading the test sample in the instrument in a given orientation;
c) peeling the adhesive tape from the development medium; and
d) measuring force to separate the tape from the medium, wherein the tape peeling test is done as a series which changes the orientation of the development medium relative to the removal of the adhesive tape to determine the direction of greatest peel strength for the development medium.

4. The method of Claim 1 wherein the development medium is a continuous web on a roll, the method further comprising: determining the directionality of the development medium having increased peel strength; winding the development medium from the roll to another roll; and dispensing the web from the roll in a thermal development apparatus thereby orienting the directionality of web to the orientation with the increased peel strength.

## Patentansprüche

1. Verfahren zum Bilden eines Reliefinusters aus einem photoempfindlichen Element, das eine Außenfläche aufweist und eine Zusammensetzungsschicht enthält, die dazu fähig ist, teilweise verflüssigt zu werden, umfassend:
das bildweise Aussetzen des photoempfindlichen Elements einer aktinischen Strahlung gegenüber, wobei das photoempfindliche Element nach dem bildweisen Aussetzen ausgehärtete Teile in den ausgesetzten Bereichen der Zusammensetzungsschicht und unausgehärtete Teile in den unausgesetzten Bereichen der Zusammensetzungsschicht enthält;
das Erhitzen der Außenfläche auf eine Temperatur, die ausreichend ist, die unausgehärteten Teile der Schicht dazu zu bringen, sich zu verflüssigen;
das Kontaktieren der Außenfläche mit einem Entwicklungsmedium, das eine vorbestimmte Direktionalität aufweist; und
das Abziehen des Entwicklungsmediums von der Außenfläche, wobei die verflüssigten Teile des photoempfindlichen Elements in Kontakt mit dem Entwicklungsmedium ebenfalls wegetragen werden;
**dadurch gekennzeichnet, dass**
der Kontaktierschritt durch Orientieren des Entwicklungsmediums durchgeführt wird, um es in der Richtung auszurichten, in der es die höchst Abziehfestigkeit aufweist, wodurch ein Bruch, Reißen oder Brechen des Mediums während der Entfernung reduziert oder eliminiert werden, wobei die Abziehfestigkeit die Abziehfestigkeit der Seite des Mediums ist, die das Element kontaktiert, was es dem Medium gestattet, die Kräfte zu überwinden, die während des Abziehens des Entwicklungsmediums von der Außenfläche aufgebracht werden, wobei die Abziehfestigkeit des Entwicklungsmediums unabhängig an einem Instrument für das Abziehtesten bestimmt wird.

2. Verfahren nach Anspruch 1, wobei das Entwicklungsmedium ein Vliesstoff ist.

3. Verfahren nach Anspruch 1, wobei das Abziehtesten an dem Instrument Folgendes umfasst:
a) das Erzeugen einer Testprobe durch Inkontaktbringen eines Klebebands mit einer Seite des Entwicklungsmediums;
b) das Laden der Testprobe in das Instrument in einer vorgegebenen Orientierung;
c) das Abziehen des Klebebands von dem Entwicklungsmedium; und
d) das Messen der Kraft zum Abtrennen des Bands von dem Medium,
wobei der Bandabziehtest als Abfolge durchgeführt wird, die die Orientierung des Entwicklungsmediums im Verhältnis zur Entfernung des Klebebands ändert, um die Richtung der stärksten Abziehfestigkeit des Entwicklungsmediums zu bestimmen.

4. Verfahren nach Anspruch 1, wobei das Entwicklungsmedium eine kontinuierliche Bahn auf einer Rolle ist, wobei das Verfahren ferner Folgendes umfasst: das Bestimmen der Direktionalität des Entwicklungsmediums, das eine erhöhte Abziehfestigkeit aufweist; das Abwickeln des Entwicklungsmediums von der Rolle auf eine andere Rolle; und das Abnehmen der Bahn von der Rolle in einem thermischen Entwicklungsapparat, wodurch die Direktionalität der Bahn zur Orientierung mit der erhöhten Abziehfestigkeit orientiert wird.

## Revendications

1. Procédé de formation d'un motif en relief à partir d'un élément photosensible ayant une surface extérieure et contenant une couche de composition capable d'être partialement liquéfiée, comprenant:
l'exposition à la manière d'une image de l'élément photosensible à un rayonnement actinique, où après l'exposition à la manière d'une image l'élément photosensible contient des parties durcies dans les zones exposées et des parties non durcies dans les zones non exposées de la couche de composition;
le chauffage de la surface extérieure à une température suffisante pour provoquer la liquéfaction des parties non durcies de la couche;
la mise en contact de la surface extérieure avec un milieu de révélation ayant une orientation prédéterminée; et
le décollement du milieu de révélation de la surface extérieure où les parties liquéfiées de l'élément photosensible en contact avec le milieu de révélation sont également emportées;
**caractérisé en ce que**
l'étape de mise en contact est exécutée par orientation du milieu de révélation pour l'aligner dans le sens ayant la force de décollement la plus grande, réduisant ou éliminant ainsi la fracture, la déchirure ou la casse du milieu durant son élimination, ladite force de décollement étant la force de décollement pour le côté du milieu se trouvant en contact avec l'élément qui permet au milieu de surmonter les forces appliquées lors du décollement du milieu de révélation de la surface extérieure, où la force de décollement du milieu de révélation est déterminée hors ligne sur un instrument de test de décollement.

2. Procédé selon la revendication 1 dans lequel le milieu de révélation est un matériau non-tissé.

3. Procédé selon la revendication 1 dans lequel le test de décollement sur l'instrument comprend:
a) la création d'un échantillon de test en plaçant une bande adhésive en contact avec un côté du milieu de révélation;
b) la charge de l'échantillon de test dans l'instrument selon un sens donné;
c) le décollement de la bande adhésive du milieu de révélation; et
d) la mesure de la force pour séparer la bande du milieu,
où le test de décollement de la bande est effectué comme une série qui change l'orientation du milieu de révélation par rapport à l'élimination de la bande adhésive pour déterminer le sens de la force de décollement la plus grande pour le milieu de révélation.

4. Procédé selon la revendication 1 dans lequel le milieu de révélation est un voile continu sur un cylindre, le procédé comprenant en outre: la détermination de l'orientation du milieu de révélation ayant une force de décollement accrue; l'enroulement du milieu de révélation du cylindre vers un autre cylindre; et la distribution du voile depuis le cylindre dans un appareil de révélation thermique dirigeant ainsi l'orientation du voile vers l'orientation avec la force de décollement accrue.
